# EUROPEAN PATENT APPLICATION

(11) **EP 4 611 501 A1**
(43) Date of publication of application: **03.09.2025**
(21) Application number: 25159033.7
(22) Date of filing: 20.02.2025
(51) Int. Cl.: H10B 63/00, G11C 13/00, H10N 70/00, H10N 70/20

(54) **THREE-DIMENSIONAL STRUCTURE OF POLARITY MEMORY CHALCOGENIDE**

(30) Priority: 23.02.2024 US 202463557106 P; 23.07.2024 US 202418781354
(71) Applicant: Micron Technology, Inc, Boise ID 83707 (US)
(72) Inventor: PIROVANO, Agostino, 20153 MILANO (IT); PELLIZZER, Fabio, BOISE, 83716 (US); TORTORELLI, Innocenzo, 20063 CERNUSCO SUL NAVIGLIO (MILANO) (IT); QUICK, Timothy A., BOISE, 83703 (US); VARESI, Enrico, BOISE, 83716 (US)
(74) Representative: Grassi, Stefano

(57) **Abstract**

A memory device having: a three-dimensional array of nodes configured on a semiconductive substrate. Each respective node in the array has a selector transistor; and a memory cell include: a first layer of conductive material configured as a first electrode terminal, the first electrode terminal connected to the selector transistor; a second layer of conductive material configured as a second electrode terminal; and a layer of a chalcogenide alloy sandwiched between the first electrode terminal and the second electrode terminal. The chalcogenide alloy includes a ternary Indium-Arsenic-Selenium material or a ternary Indium-Arsenic-Tellurium material, deposited using a technique of atomic layer deposition.

## Description

### TECHNICAL FIELD

At least some embodiments disclosed herein relate to three-dimensional memory array structures in general and more particularly, but not limited to, memory array structures for memory cells implemented using chalcogenide alloy.

### BACKGROUND

A memory sub-system can include one or more memory devices that store data. The memory devices can be, for example, non-volatile memory devices and volatile memory devices. In general, a host system can utilize a memory sub-system to store data at the memory devices and to retrieve data from the memory devices.

A memory device can include a memory integrated circuit having one or more arrays of memory cells formed on an integrated circuit die of semiconductive material. A memory cell is a smallest unit of memory that can be individually used or operated upon to store data. In general, a memory cell can store one or more bits of data.

Different types of memory cells have been developed for memory integrated circuits, such as random access memory (RAM), read-only memory (ROM), dynamic random access memory (DRAM), static random access memory (SRAM), synchronous dynamic random access memory (SDRAM), phase change memory (PCM), magneto random access memory (MRAM), negative-or (NOR) flash memory, electrically erasable programmable read-only memory (EEPROM), flash memory, etc.

Some integrated circuit memory cells are volatile and require power to maintain data stored in the cells. Examples of volatile memory include dynamic random-access memory (DRAM) and static random-access memory (SRAM).

Some integrated circuit memory cells are non-volatile and can retain stored data even when not powered. Examples of non-volatile memory include flash memory, read-only memory (ROM), programmable read-only memory (PROM), erasable programmable read-only memory (EPROM) and electronically erasable programmable read-only memory (EEPROM) memory, etc. Flash memory includes NAND-type flash memory or a NOR-type flash memory. A NAND-type memory cell is based on a NAND logic gate; and a NOR-type memory cell is based on a NOR logic gate.

An integrated circuit memory cell can be programmed to store data by applying a voltage or a pattern of voltage to the memory cell during a program/write operation. The program/write operation sets the memory cell in a state that corresponds to the data being programmed/stored into the memory cell. The data stored in the memory cell can be retrieved in a read operation by examining the state of the memory cell. For example, a read operation can determine the state of a memory cell by applying a voltage and determining whether the memory cell becomes conductive.

### BRIEF DESCRIPTION OF THE DRAWINGS

The embodiments are illustrated by way of example and not limitation in the figures of the accompanying drawings in which like references indicate similar elements.
**FIG. 1** illustrates a three-dimensional structure of a memory according to one embodiment.
**FIG. 2** shows nodes containing memory cells in a memory array according to one embodiment.
**FIGS. 3A****,** **3B****,** **4** and **5** show examples of a memory cell configured in a node according to some embodiments.
**FIG. 6** illustrates the structure of two adjacent stacks of nodes in a vertical plane according to one embodiment.
**FIG. 7** shows a circuit representation of two adjacent stacks of nodes configured in a three dimensional array according to one embodiment.
**FIG. 8** shows a memory device configured with a controller and voltage drivers to program and read memory cells in a three dimensional array according to one embodiment.
**FIG. 9** shows a bitline driver and a wordline driver connected to select a memory cell configured in a three dimensional array according to one embodiment.
**FIG. 10** shows an example computing system having memory cells configured in a three dimensional array according to one embodiment.
**FIG. 11** shows a method to access memory cells in a three dimensional array according to one embodiment.

### DETAILED DESCRIPTION

At least one embodiment disclosed herein provides a high density memory cell array implemented via chalcogenide alloy, such as a ternary Indium-Arsenic-Selenium material, or a ternary Indium-Arsenic-Tellurium material. For example, the memory cells can be configured in a three-dimensional node array. Each node in the array is configured to have one transistor and one memory cell having chalcogenide alloy sandwiched between a top-electrode terminal (e.g., a first electrode terminal) and a bottom-electrode terminal (e.g., a second electrode terminal). The drain of the transistor can be connected to the bottom-electrode terminal of the memory cell. A set of horizontal conductive plates are configured in the array to connect bitline signals to the gates of the transistors configured in the three-dimensional node array. Two sets of vertical conductive pillars are configured in the array. One set of vertical conductive pillars are connected to the sources of the transistors configured in the three-dimensional node array; and another set of vertical conductive pillars are connected to the top-electrode terminals of the memory cells configured in the three-dimensional node array. Thus, each node is connected between two vertical pillars, one from each of the two sets, as further discussed below.

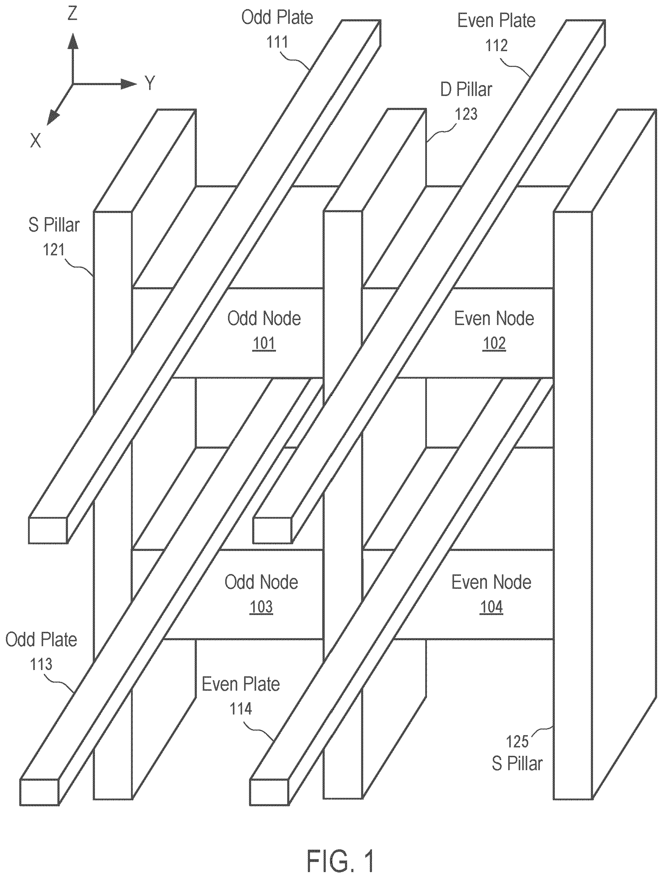

**FIG. 1** illustrates a three-dimensional structure of a memory according to one embodiment.

In **FIG. 1**, horizontal layers of nodes (e.g., 101, 102 in a layer; 103, 104 in another layer) are stacked in a vertical direction (e.g., along Z-axis).

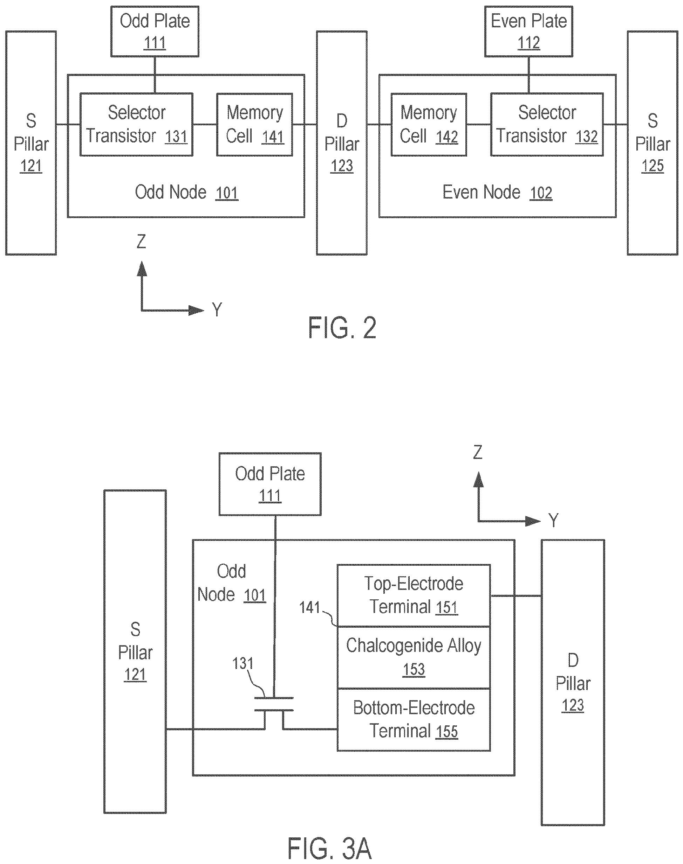

Each node (e.g., 101, 102, 103, or 104) in the three-dimensional array contains one transistor and one memory cell connected to the transistor (e.g., , as illustrated in **FIG. 2** to **FIG. 5**). The gate of the transistor in the node (e.g., 101, 102, 103, or 104) is connected to a conductive plate (e.g., 111, 112, 113, or 114) that is configured to extend in a first horizontal direction (e.g., along X-axis).

The conductive plate (e.g., 111, 112, 113, or 114) is configured to carry a voltage controlling the selection of a row of nodes, where the gates of the transistors in the row of nodes are connected to the same conductive plate (e.g., 111, 112, 113, or 114). The row of nodes is arranged to extend in a horizontal layer in the same direction as the conductive plate (e.g., 111, 112, 113, or 114) (e.g., in the first horizontal direction along X-axis in **FIG. 1**).

**FIG. 1** illustrates two adjacent stacks of nodes in a vertical slice of the three-dimensional array extending in a second horizontal direction (e.g., along Y-axis). Each stack of nodes (e.g., 101, 103 in one stack; or 102, 104 in another stack) is configured between, and connected to, two vertical conductive pillars (e.g., 121 and 123 for one stack; or 123 and 125 for another stack). The two adjacent stacks can share a common vertical conductive pillar (e.g., 123).

The structure of the two stacks of nodes (e.g., 101, 103 in one stack; and 102, 104 in another stack) as illustrated in **FIG. 1** can be repeated in the second horizontal direction (e.g., along Y-axis) to form a vertical slice of nodes extending in the second horizontal direction (e.g., along Y-axis). The structure of such a vertical slice of nodes can be further repeated in the first horizontal direction to provide a plurality of vertical slices of nodes in a three-dimensional array.

In **FIG. 1**, the stacks of nodes in a vertical slice extending in the second horizontal direction (e.g., along Y-axis) can be numbered consecutively for convenience in referencing. An odd-numbered stack (e.g., having odd nodes 101, 103) and an even-numbered stack (e.g., having even nodes 102, 104) are connected to, and thus share, a common vertical pillar 123 that is configured between the two stacks.

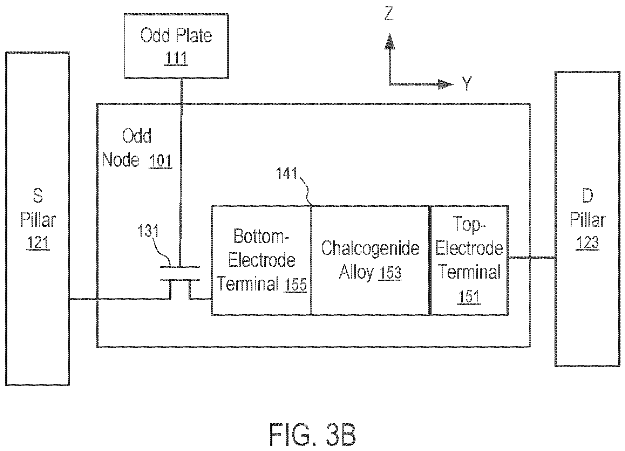

The drain of the transistor in an odd node (e.g., 101) is connected to a bottom-electrode terminal of the memory cell in the odd node (e.g., 101) (e.g., as illustrated in **FIG. 3A** and **FIG. 3B**). The source of the transistor in the odd node (e.g., 101) is connected to a pillar 121, referred to as an S pillar for being closer to the source of the transistor than to the drain of the transistor. The top-electrode terminal of the memory cell in the odd node (e.g., 101) is connected to a pillar 123 (e.g., as illustrated in **FIG. 3A** and **FIG. 3B**), referred to as a D pillar for being closer to the drain of the transistor than to the source of the transistor.

Similarly, the drain of the transistor in an even node (e.g., 102) is connected to a bottom-electrode terminal of the memory cell in the even node (e.g., 102). The source of the transistor in the even node (e.g., 102) is connected to an S pillar 125. The top-electrode terminal of the memory cell in the even node (e.g., 102) is connected to the D pillar 123.

When a further odd-numbered stack is added to the right of the even-numbered stack (e.g., even nodes 102, 104), the further odd-numbered stack and the even-numbered stack (e.g., even nodes 102, 104) can be connected to, and thus share, the common S pillar 125 configured between the two stacks.

Similarly, when a further even-numbered stack is added to the left of the odd-numbered stack (e.g., odd nodes 101, 103), the further even-numbered stack and the order-numbered stack (e.g., odd nodes 101, 103) can be connected to, and thus share, the common S pillar 121 configured between the two stacks.

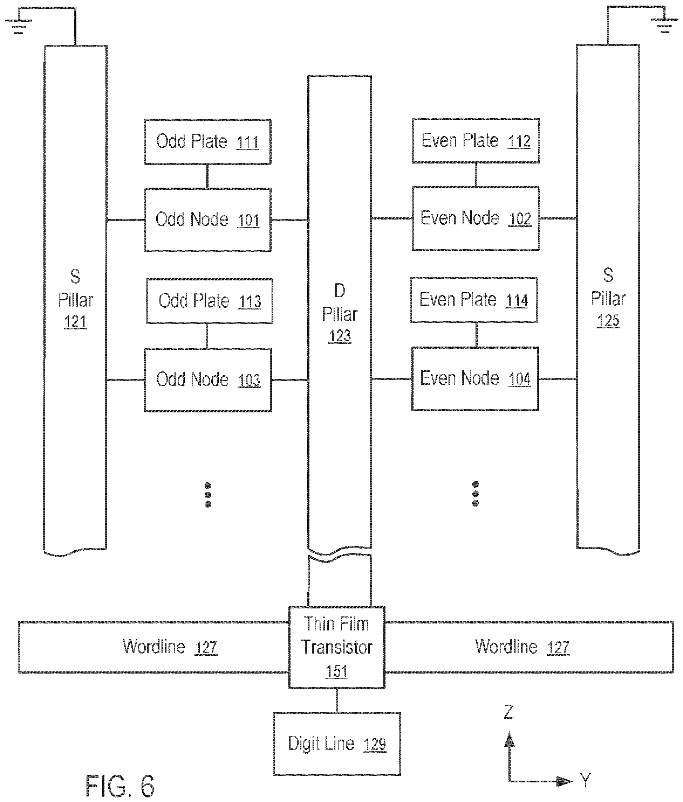

In some embodiments, S pillars (e.g., 121, 125) are connected to ground (or biased to another voltage); and D pillars (e.g., 123) configured in a vertical slice are connected to a set of thin film transistors (TFT) controlled by a wordline to enable wordline selection (e.g., as illustrated in **FIG. 6**).

For example, the drains (or sources) of the thin film transistors (TFT) (e.g., 151 in **FIG. 6**) can be connected to the D pillars (e.g., 123) in the vertical slice; the sources (or drains) of the thin film transistors (TFT) can be connected to digit lines for the detection of currents going through the D pillars (e.g., 123); and the gates of the thin film transistors (TFT) are connected to a wordline running horizontally in parallel with the vertical slice of nodes.

The horizontal plates (e.g., 111, 112, 113, 114) can be connected to bitlines to enable bitline selection.

Thus, each memory cells in the three-dimensional array of nodes (e.g., 101, 102, 103, or 104) can be selectively addressed via activating a bitline and a wordline.

For example, when the voltage applied on the bitline is sufficient to turn on the transistors connected to a horizontal plate (e.g., 111) connected to the bitline, and when the voltage applied on the wordline 127 is sufficient to turn on the thin film transistors (e.g., 151) connected to the wordline 127, the activation of the thin film transistors (e.g., 151) connected to the wordline 127 in the vertical slice and the activation of the transistors in the row of nodes (e.g., 101) connected to the horizontal plate (e.g., 111) causes the node 101 in the row and in the vertical slice to be connected between the voltage (e.g., ground) applied to the S pillar 121 and a voltage applied to the digit line 129. The voltage difference between the digit line 129 and the S pillar 121 can be configured to program the memory cell in the node 101 to a state representative of data stored in the memory cell and/or to examine the state of the memory and thus retrieve data from the memory cell.

When the voltage on a horizontal plate (e.g., 113) is insufficient to turn on the transistors connected to the plate (e.g., 113), the transistors connected to the plate (e.g., 113) isolate the memory cells in a row from their S pillars (e.g., 121).

Similarly, when the voltage on the wordline 127 is insufficient to turn on the thin film transistors (e.g., 151) connected to the wordline 127, the thin film transistors (e.g., 151) isolate the D pillars (e.g., 123) from the digit line (e.g., 129) and thus isolate their connected memory cells (e.., in nodes 101, 103; 102, 104) in the vertical slice from the digit lines (e.g., 129).

Thus, selectively applying voltages to wordlines and bitlines can selectively address the memory cells in the three-dimensional array of nodes (e.g., 101, 103; 102, 104) for read and write operations.

Each node (e.g., 101, 102, 103, or 104) in the three-dimensional array can be implemented in a way as illustrated in **FIG. 2**, **FIG. 3A**, **FIG. 3B**, **FIG. 4**, and/or **FIG. 5**.

**FIG. 2** shows nodes containing memory cells in a memory array according to one embodiment. For example, representative nodes 101 and 102 in the three-dimensional array of **FIG. 1** can be implemented in a way as shown in **FIG. 2**.

**In** **FIG. 2****,** an odd node 101 has a memory cell 141 and a selector transistor 131 that connects an S pillar 121 to a D pillar 123 (e.g., in a three-dimensional array as shown in **FIG. 1**) via the memory cell 141. For example, when the odd plate 111 has a voltage that turns off the selector transistor 131, the source-drain channel of the selector transistor 131 closes to prevent the memory cell 141 from being subjected to the voltage difference driven between the S pillar 121 and the D pillar 123.

When the odd plate 111 has a voltage that turns on the selector transistor 131, the source-drain channel of the selector transistor 131 opens to cause the memory cell 141 to be applied the voltage difference driven between the S pillar 121 and the D pillar 123. If the applied voltage difference is higher than the threshold voltage of the memory cell 141, a current that is more than a predetermined threshold can flow between the S pillar 121 and the D pillar 123 through the odd node 101. If the applied voltage difference is lower than the threshold voltage of the memory cell 141, a small leak can flow between the S pillar 121 and the D pillar 123 through the odd node 101. Thus, by sensing the magnitude of the current going through the D pillar 123, the state of the threshold voltage of the memory cell 141 can be examined to determine the data programmed into the memory cell 141 in a read operation to retrieve the data.

Similarly, an even node 102 has a memory cell 142 and a selector transistor 132 that connects an S pillar 125 to the D pillar 123 (e.g., in a three-dimensional array as in **FIG. 1**) via the memory cell 142. When the even plate 112 has a voltage that turns off the selector transistor 132, the memory cell 142 is not subjected to a voltage difference driven between the S pillar 125 and the D pillar 123. When the even plate 112 has a voltage that turns on the selector transistor 132, the memory cell 142 is subjected to the voltage difference driven between the S pillar 125 and the D pillar 123. The voltage difference can be applied to program the memory cell 142 to a state and thus store data represented by the state in the memory cell 142, or to examine the state of the memory cell 142 to retrieve the data programmed into the memory cell 142.

The memory cells 141 and 142 can be selectively addressed via selectively turning on or off the selector transistors 131 and 132 using different bitline signals applied to the different horizontal plates 111 and 112.

The memory cells 141 and 142 in **FIG. 2** can have a structure of a memory cell 141 shown in **FIG. 3A** and **FIG. 3B**.

**FIG. 3A** shows a memory cell configured in a node according to one embodiment.

**In** **FIG. 3A****,** an odd node 101 (e.g., as in **FIG. 1** and/or **FIG. 2**) has a plurality of layers of materials stacked in the vertical direction (e.g., along Z-axis) to form a memory cell 141. The selector transistor 131 is configured to have a horizontal source-drain channel connecting from an S pillar 121 (e.g., as in **FIG. 1** and/or **FIG. 2**) to the bottom-electrode terminal 155 of the memory cell 141. The top-electrode terminal 151 is connected to a D pillar 123. The gate of the selector transistor 131 is connected to and controlled by an odd plate 111 configured above the node 101. A chalcogenide alloy 153 is configured between the top-electrode terminal 151 and bottom-electrode terminal 155 to form the memory cell 141.

In some implementations, when the forming of the chalcogenide alloy 153 in the memory cell 141 is replaced with depositing an isolation material between the top-electrode terminal 151 and the bottom electrode terminal 155 of the memory cell 141, the odd node 101 is reduced to have a dynamic random access memory (DRAM) cell. In some implementations, when the forming of the chalcogenide alloy 153 in the memory cell 141 is replaced with depositing a ferroelectric material between the top-electrode terminal 151 and the bottom electrode terminal 155 of the memory cell 141, the odd node 101 is reduced to have a ferroelectric random access memory (FeRAM) cell. Thus, a manufacturing facility can change between producing three-dimensional chalcogenide memory cells, three-dimensional DRAM cells and/or three-dimensional FeRAM cells, with minimum adjustments in the disposing of the material between the top-electrode terminal 151 and bottom-electrode terminal 155.

**FIG. 3A** illustrates a configuration where the source-drain channel of the transistor 131 is connected between one electrode terminal 155 of the memory cell 141 and the S pillar 121, with the D pillar 123 being connected to the other electrode terminal 151 of the memory cell 141. Alternatively, the source-drain channel of the transistor 131 can be connected between one electrode terminal 155 of the memory cell 141 and the D pillar 123, with the S pillar 121 being connected to the other electrode terminal 151 of the memory cell 141.

**FIG. 3A** illustrates an example of an odd node 101. An even node 102 (e.g., in **FIG. 1** and/or **FIG. 2**) can be formed in a similar way. **FIG. 3A** illustrates an example in which the electrode terminals 151 and 155 and the chalcogenide alloy 153 are stacked along Z-axis. For example, a first layer of conductive material is configured as a first electrode terminal (e.g., 155) of the memory cell 141, where the first electrode terminal (e.g., 155) is connected to the selector transistor 131; a second layer of conductive material is configured as a second electrode terminal (e.g., 151) of the memory cell 141, where the second electrode terminal (e.g., 151) is connected to the pillar 123; and a layer of a chalcogenide alloy 153 is sandwiched between the first electrode terminal (e.g., 155) and the second electrode terminal (e.g., 151). In another implementation, the layers of the electrode terminals 151 and 155 and the chalcogenide alloy 153 are stacked along Y-axis, as illustrated in **FIG. 3B**.

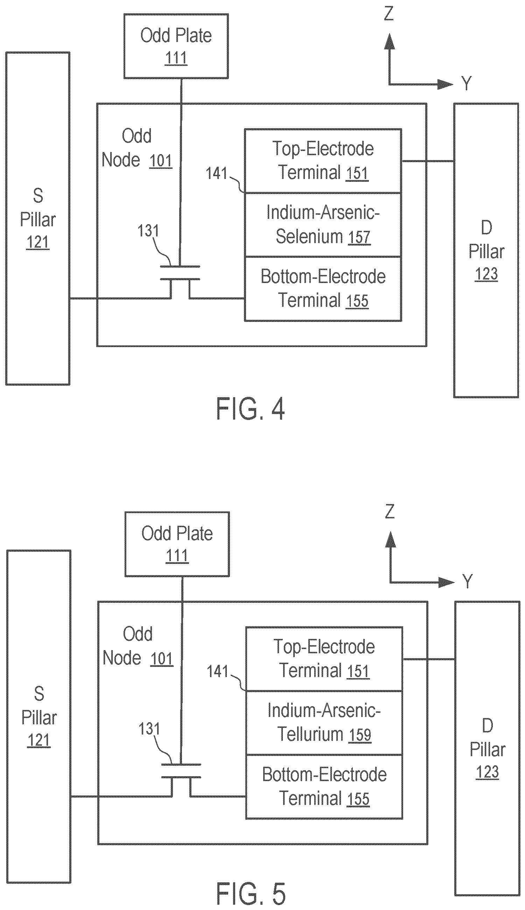

In some implementations, the chalcogenide alloy 153 of the memory cell 141 is a ternary Indium-Arsenic-Selenium material 157, as in **FIG. 4**, deposited using a technique of atomic layer deposition (ALD), or another technique (e.g., physical vapor deposition (PVD), chemical vapor deposition (CVD)). **FIG. 4** illustrates an example in which the electrode terminals 151 and 155 and the Indium-Arsenic-Selenium material 157 are stacked along Z-axis. In another implementation, the layers of the electrode terminals 151 and 155 and the Indium-Arsenic-Selenium material 157 are stacked along Y-axis, in a way similar to the stacking illustrated in **FIG. 3B**. In some implementations, the Indium-Arsenic-Selenium material 157 can be replaced with a storage element, a doped compound, a chalcogenide material, or other alloy including selenium (Se), tellurium (Te), arsenic (As), antimony (Sb), carbon (C), germanium (Ge), silicon (Si), or indium (In), or various combinations thereof. In some examples of storage elements, a chalcogenide material having primarily selenium (Se), arsenic (As), and germanium (Ge) may be referred to as a SAG-alloy. In some examples of storage elements, a SAG-alloy may also include silicon (Si) and such chalcogenide material may be referred to as SiSAG-alloy. In some examples of storage elements, SAG-alloy may include silicon (Si) or indium (In) or a combination thereof and such chalcogenide materials may be referred to as SiSAG-alloy or InSAG-alloy, respectively, or a combination thereof. In some examples of storage elements, the chalcogenide glass may include additional elements such as hydrogen (H), oxygen (O), nitrogen (N), chlorine (CI), or fluorine (F), each in atomic or molecular forms.

In some implementations, the chalcogenide alloy 153 of the memory cell 141 is a ternary Indium-Arsenic-Tellurium material 159, as in **FIG. 5**, deposited using a technique of atomic layer deposition (ALD), or another technique (e.g., physical vapor deposition (PVD), chemical vapor deposition (CVD)). **FIG. 5** illustrates an example in which the electrode terminals 151 and 155 and the Indium-Arsenic-Tellurium material 159 are stacked along Z-axis. In another implementation, the layers of the electrode terminals 151 and 155 and the Indium-Arsenic-Tellurium material 159 are stacked along Y-axis, in a way similar to the stacking illustrated in **FIG. 3B**. In some implementations, Indium-Arsenic-Tellurium material 159 can be replaced with a storage element, a doped compound, a chalcogenide material, or other alloy including selenium (Se), tellurium (Te), arsenic (As), antimony (Sb), carbon (C), germanium (Ge), silicon (Si), or indium (In), or various combinations thereof. In some examples of storage elements, a chalcogenide material having primarily selenium (Se), arsenic (As), and germanium (Ge) may be referred to as a SAG-alloy. In some examples of storage elements, a SAG-alloy may also include silicon (Si) and such chalcogenide material may be referred to as SiSAG-alloy. In some examples of storage elements, SAG-alloy may include silicon (Si) or indium (In) or a combination thereof and such chalcogenide materials may be referred to as SiSAG-alloy or InSAG-alloy, respectively, or a combination thereof. In some examples of storage elements, the chalcogenide glass may include additional elements such as hydrogen (H), oxygen (O), nitrogen (N), chlorine (CI), or fluorine (F), each in atomic or molecular forms.

When a chalcogenide alloy is deposited using a technique of atomic layer deposition (ALD) or a technique of physical vapor deposition (PVD) (for being disposed between the terminals 151 and 155), the memory cell 141 can have a polarity induced threshold window. Such a memory cell 141 can be programmed with a low programming current (e.g., lower than 50 µA, such as approximately 40 µA), and can have good endurance (e.g., to endure more than 10k cycles of programming). Such a memory cell 141 can be programmed to have different threshold voltages for voltages applied in different polarities to the memory cell 141. When Selenium in the chalcogenide alloy 153 is replaced with Tellurium, the alloy energy gap can be further reduced, which reduces both set and reset threshold voltages. A set threshold voltage is a threshold voltage of the memory cell 141 programmed to represent the state of being set (e.g., to represent the bit value of one being stored in the memory cell 141); and a reset threshold voltage is a threshold voltage of the memory cell 141 programmed to represent the state of being reset (e.g., to represent the bit value of zero being stored in the memory cell 141). For example, the difference between a set threshold voltage and a reset threshold voltage can be referred to as a threshold window.

**FIG. 6** illustrates the structure of two adjacent stacks of nodes in a vertical plane according to one embodiment.

In **FIG. 6**, an odd-numbered stack of odd nodes (e.g., 101, 103) are arranged in the vertical direction (e.g., along Z-axis); and an even-numbered stack of even nodes (e.g., 102, 104) are configured next to the odd-numbered stack. For example, the three-dimensional structure of the nodes (e.g., 101, 103; 102, 104) can be configured in a way similar to what is illustrated in **FIG. 1**.

Adjacent layers of nodes (e.g., 101 and 103) stacked in the vertical direction (e.g., along Z-axis) can be separated by a layer of dielectric region configured on a substrate of a semiconductive device.

Each node (e.g., 101, 102, 103, or 104) in the stacks can be configured to have a selector transistor (e.g., 131) and a memory cell (e.g., 141) in a way similar to those illustrated in **FIG. 2**, **FIG. 3A**, **FIG. 3B**, **FIG. 4**, and/or **FIG. 5**.

In **FIG. 6**, the D pillar 123 is connected to a digit line 129 via a thin film transistor 151 formed through a wordline 127. The conductive wordline 127 surrounds the thin film transistor 151 to control the gate of the thin film transistor 151. The source-drain channel of the thin film transistor 151 connects the D pillar to, or disconnects from, the digit line 129 based on the voltage applied on the wordline 127.

For example, when the voltage applied on the wordline 127 turns on the thin film transistor 151, the source-drain channel of the thin film transistor 151 connects the D pillar 123 to the digit line 129. When the voltage applied on the wordline 127 turns off the thin film transistor 151, the source-drain channel of the thin film transistor 151 disconnects the D pillar 123 from the digit line 129.

Thus, the wordline 127 and a set of thin film transistors (e.g., 151) configured on the wordline 127 can selectively connect a set of digit lines (e.g., 129) to the D pillars (e.g., 123) configured in the vertical slice of the three-dimensional array of nodes.

The digit line 129 can extend in X-axis (perpendicular to Y-axis and Z-axis). A row of D pillars (e.g., 123) configured in a vertical plane in parallel with the digit line 129 can be connected to the same digit line 129.

The S-pillars (e.g., 121, 125) are connected to ground (or biased at another voltage). The digit lines (e.g., 129) can be connected to voltage drivers and current sensors to drive voltages on D pillars (e.g., 123) and sensing magnitudes of currents going through the D pillars (e.g., 123) to the digit lines (e.g., 129).

For example, a voltage driver connected to the digit line 129 can be instructed to drive a voltage higher than ground (or the biased voltage of the S pillars 121, 125) to apply a voltage in the positive polarity; and the voltage driver connected to the digit line 129 can be instructed to drive a voltage lower than ground (or the biased voltage of the S pillars 121, 125) to apply a voltage in the negative polarity.

A memory cell (e.g., 141 or 142) with a chalcogenide alloy 153 (e.g., Indium-Arsenic-Selenium 157 as in **FIG. 4**) or Indium-Arsenic-Tellurium 159 as in **FIG. 5**) can have different threshold voltages of different magnitudes in different polarity. Having a threshold voltage in a first polarity (e.g., positive polarity) larger than a threshold voltage in a second polarity (e.g., negative polarity) can be used to indicate that the memory cell (e.g., 141 or 142) is in a set state (e.g., to store a bit value of one); and having a threshold voltage in the first polarity (e.g., positive polarity) smaller than a threshold voltage in the second polarity (e.g., negative polarity) can be used to indicate that the memory cell (e.g., 141 or 142) in a reset state (e.g., to store a bit value of zero). For example, during a write operation, applying a voltage in a first polarity may result in the cell having a first threshold voltage (e.g., a set threshold voltage); and applying a voltage in a second polarity may result in the cell having a second threshold voltage (e.g., a reset threshold voltage) higher than the first (set) threshold voltage when the threshold voltage of the cell is read in the first polarity after the write pulse. Similarly, during a write operation, applying a voltage in a first polarity may result in the cell having a first threshold voltage (e.g., a reset threshold voltage); and applying a voltage in a second polarity may result in the cell having a second threshold voltage (e.g., a set threshold voltage) lower than the first (reset) threshold voltage when the threshold voltage of the cell is read in the second polarity after the write pulse.

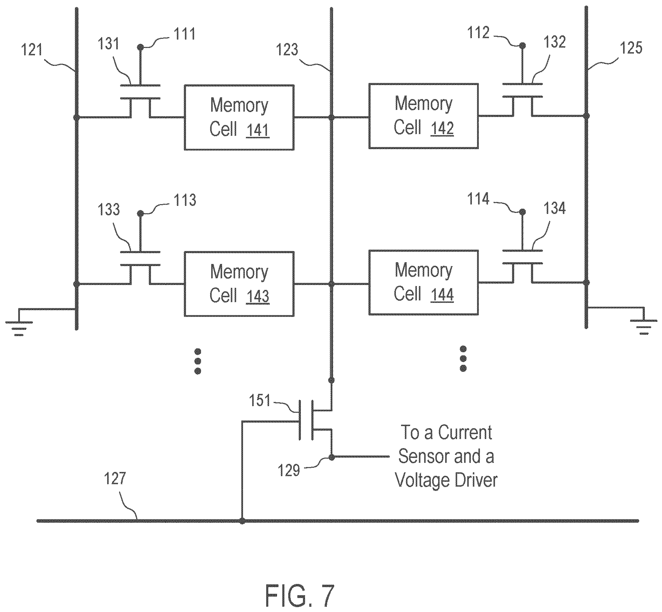

**FIG. 7** shows a circuit representation of two adjacent stacks of nodes configured in a three dimensional array according to one embodiment.

In **FIG. 7**, two stacks of memory cells (e.g., 141, 143; 142, 144) (e.g., implemented in two stacks of nodes illustrated in **FIG. 1** and/or **FIG. 6**) are connected between a D pillar 123 and S pillars 121 and 125 via selector transistors (e.g., 131, 133; 132, 134). The S pillars are biased at ground (or another voltage). The D pillar 123 can be connected via a thin film transistor 151 to a current sensor and a voltage driver. The gate of the transistor 151 is controlled by a wordline 127.

When the voltage on the wordline 127 turns on the transistor 151, the voltage driven by the voltage driver is applied to the D pillar 123; and the current going through the D pillar 123 can be sensed, measured, and/or detected by the current sensor to determine whether the voltage difference between the D pillar 123 and the S pillars 121 and 125 is above a threshold.

When the voltage on the wordline 127 turns of the transistor 151, the D pillar 123 is isolated from the current sensor and the voltage driver.

The digit line 129 can be configured as a horizontal plate running in the same direction as the odd plates (e.g., 111, 113) and even plates (e.g., 112, 114) (e.g., along the X-axis). The D pillars (e.g., 123) configured above the digit line 129 can be each connected to the same digit line 129 via a respective thin film transistor (e.g., 151) controlled by a respective wordline (e.g., 127). Thus, a row of D pillars (e.g., 123) connected to the digit line 129 can share the same current sensor and the same voltage driver.

The odd plates (e.g., 111, 113) and the even plates (e.g., 112, 114) can be connected to separate bitlines. A memory cell (e.g., 141) in the array can be addressed by activating a bitline (e.g., connected to odd plate 111) and a wordline (e.g., 127) to program the memory cell for storing data and to determine the state of the memory cell (e.g., 141) for retrieving the data stored in the memory cell (e.g., 141).

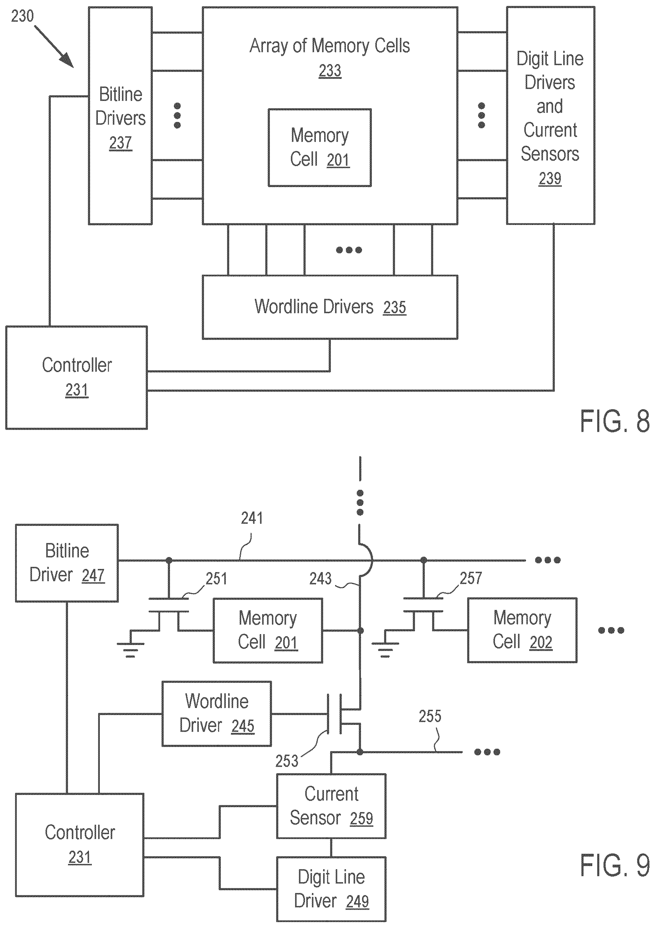

**FIG. 8** shows a memory device 230 configured with a controller 231 and voltage drivers (e.g., 237, 235) to program and read memory cells in a three dimensional array according to one embodiment.

For example, the array of memory cells 233 in **FIG. 8** can be arranged in a three-dimensional array of nodes as in **FIG. 1**; and a representative memory cell 201 in the array of memory cells 233 can have a structure of a memory cell 141 in a node 101 **in** **FIG. 3A**, **FIG. 3B**, **FIG. 4**, or **FIG. 5**.

The memory device 230 of **FIG. 8** includes a controller 231 that operates bitline drivers 237 and wordline drivers 235 to address the individual memory cells (e.g., 201) in the array 233 for access, such as programming the memory cells being addressed/selected to store data in write operations, examining the states of the memory cells being addressed/selected to determine in read operation data programmed into the memory cells.

The memory device 230 includes digit line drivers and current sensors 239. When a memory cell 201 is addressed for a write operation, a digit line driver can apply one or more voltage pulses to program the memory cell 201 to have a state representative of data to be written into the memory cell 201.

When a memory cell 201 is addressed for a read operation, a digit line driver can apply one or more voltages to examine the state the memory cell 201. The controller 231 uses a current sensor to determine whether the addressed memory cell 201 is in a conductive state or a non-conductive state based on the magnitude/level of the current passing through the memory cell 201.

For example, each memory cell (e.g., 201) in the array 233 can be selected/addressed via voltages driven by a pair of a bitline driver 247 and a wordline driver 245 for access, as illustrated in **FIG. 9**.

**FIG. 9** shows a bitline driver 247 and a wordline driver 245 connected to select a memory cell 201 configured in a three dimensional array according to one embodiment, such as a memory cell in a three dimensional array of nodes as shown in FIG. 1.

In **FIG. 9**, the bitline driver 247, the wordline driver 245, a current sensor 259, and a digit line driver 249 are controlled by a controller 231, such as a controller 231 of a memory device 230 of **FIG. 8**. The current sensor 253 can be used to determine the magnitude of the current in the digit line 255 driven by the digit line driver 249.

The memory cell 201 can be configured in a node (e.g., 101, 102, 103, or 104) in a three dimensional array (e.g., as in **FIG. 1**). The node also includes a selector transistor 251 for the selection of the memory cell 201 via a bitline voltage driven by the bitline driver 247 on a line 241. For example, the line 241 can be connected to a horizontal plate (e.g., 111, 112, 113, or 114) configured above the node in the three dimensional array (e.g., as in **FIG. 1**).

The source-drain channel of the selector transistor 251 is connected between a reference voltage (e.g., ground, or another voltage) and one terminal of the memory cell 201. The gate of the selector transistor 251 is connected to the line 241 to receive the bitline voltage driven by the bitline driver 247.

The other terminal of the memory cell 201 is connected to a common line 243 (e.g., a vertical conductive pillar 123 in **FIG. 1**) shared with a set of memory cells in the array. The bitline voltage driven by the bitline driver 247 is connected to control selection/deselection of the memory cell 201 among the set of memory cells share the line 243.

The line 243 shared by the set of memory cells (e.g., 201) is connected by the source-drain channel a transistor 253 controlled by a wordline driver 245 (e.g., via a wordline 127 shown in **FIG. 6** and **FIG. 7**) to a digit line 255. The wordline voltage from the wordline driver 245 selectively opens or closes the transistor 253.

When the wordline driver 245 and the bitline driver 247 turn on the transistors 253 and 251 respectively, the memory cell 201 is connected between the reference voltage (e.g., ground, or another voltage) and the voltage driven by the digit line driver 249 on the digit line 255. Thus, the memory cell 201 is selected/addressed for read/write access.

When either the wordline driver 245 turns off the transistor 253 or the bitline driver 247 turns of the transistor 251 respectively (or both), the memory cell 201 is disconnected from the voltage differences between the reference voltage (e.g., ground, or another voltage) and the voltage driven by the digit line driver 249 on the digit line 255. Thus, the memory cell 201 is de-selected or not addressed for read/write access.

For example, when the memory cell 201 is selected/addressed, the digit line driver 249 can apply a voltage higher than the reference voltage (e.g., ground, or another voltage) to apply a voltage difference of a positive polarity to the memory cell 201. The memory cell 201 can have a threshold voltage in the positive polarity. When the voltage difference of the positive polarity applied to the memory cell 201 is smaller than the threshold voltage in the positive polarity, the memory cell 201 is substantially non-conductive (e.g., the current going through the memory cell 201 is smaller than a threshold). When the voltage difference of the positive polarity applied to the memory cell 201 is larger than the threshold voltage in the positive polarity, the memory cell 201 is substantially conductive (e.g., the current going through the memory cell 201 is larger than a threshold).

For example, when the memory cell 201 is selected/addressed, the digit line driver 249 can apply a voltage lower than the reference voltage (e.g., ground, or another voltage) to apply a voltage difference of a negative polarity to the memory cell 201. The memory cell 201 can have a threshold voltage in the negative polarity. When the voltage difference of the negative polarity applied to the memory cell 201 is smaller than the threshold voltage in the negative polarity, the memory cell 201 is substantially non-conductive (e.g., the current going through the memory cell 201 is smaller than a threshold). When the voltage difference of the negative polarity applied to the memory cell 201 is larger than the threshold voltage in the negative polarity, the memory cell 201 is substantially conductive (e.g., the current going through the memory cell 201 is larger than a threshold).

The difference between the threshold voltage after a programming pulse in the negative polarity and the threshold voltage after a programming pulse in the positive polarity represents a polarity induced threshold window of the memory cell 201. A large polarity induced threshold window allows reliable detection of the state of the memory cell 201.

During a write operation, the controller 231 can instruct the digit line driver 249 to apply one or more voltage pulses to change the threshold voltages of the memory cell 201. For example, the memory cell 201 can be programmed to have the threshold voltage in the negative polarity smaller than the threshold voltage in the positive polarity to represent one state (e.g., representative of a bit value of one stored in the memory cell 201); and the memory cell 201 can be programmed to have the threshold voltage in the negative polarity larger than the threshold voltage in the positive polarity to represent another state (e.g., representative of a bit value of zero stored in the memory cell 201). The threshold window allows the memory cell to be read using various techniques; and thus, it is not necessary to read the memory cell in both polarities to determine the state of the memory cell and thus the data stored in the memory cell.

The bitline voltage driven by the bitline driver 247 can be connected selector transistors (e.g., 251, 257) of a row of memory cells (e.g., 201, 202). The row of memory cells (e.g., 201, 202) can be arranged in different vertical slices of the three-dimensional array of nodes, and connected to a common horizontal plate (e.g., 111). Different memory cells (e.g., 201, 202) are connected to different D pillars (e.g., 123) what are controlled by different wordlines (e.g., 127) running in respective vertical slices. The selection/addressing of the memory cells (e.g., 201, 202) in the row is controlled by different wordlines. Since the memory cells (e.g., 201, 202) in the row are selected/addressed one at a time, the D pillars connected to the memory cells (e.g., 201, 202) in the row can be connected via separate transistors (e.g., 253), controlled by separate wordline drivers (e.g., 245), to the same digit line 255 driven by the same digit line driver 249.

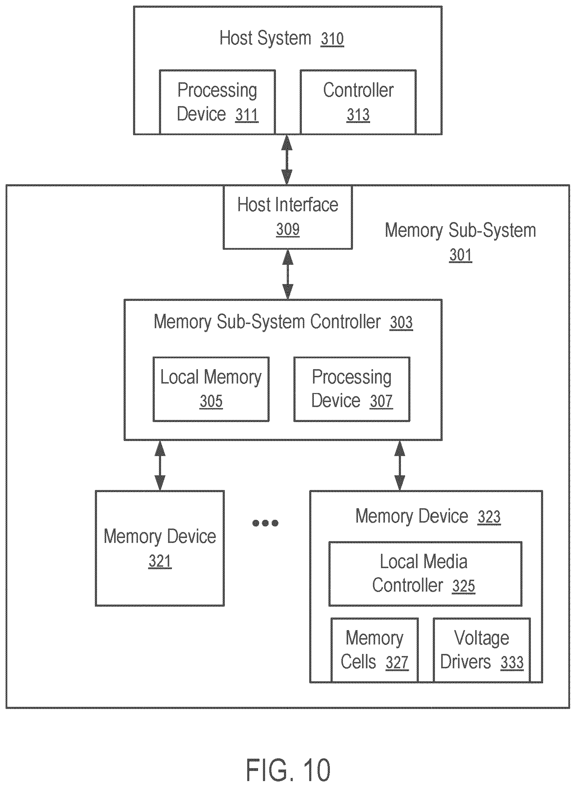

**FIG. 10** shows an example computing system having memory cells configured in a three dimensional array according to one embodiment, such as a node array as shown in **FIG. 1**

The example computing system of **FIG. 10** includes a host system 310 and a memory sub-system 301. A set of memory cells (e.g., having configured in nodes of a three-dimensional array as discussed in connection with **FIG. 1** to **FIG. 9**) can be configured in the memory sub-system 301, or in the host system 310.

For example, the memory cells 327 in the memory device 323 can be configured in a three-dimensional node array as in **FIG. 1** and **FIG. 6**, with selector transistors and memory cell structures as in **FIG. 2** to **FIG. 5**. The local media controller 325 can use the voltage drivers 333 to apply bitline voltages, wordline voltages, and digit line voltages, as the controller 231 of **FIG. 8** and **FIG. 9**.

The memory sub-system 301 can include media, such as one or more volatile memory devices (e.g., memory device 321), one or more non-volatile memory devices (e.g., memory device 323), or a combination of such.

The memory sub-system 301 can be a storage device, a memory module, or a hybrid of a storage device and memory module. In general, examples of a storage device include a solid-state drive (SSD), a flash drive, a universal serial bus (USB) flash drive, an embedded multi-media controller (eMMC) drive, a universal flash storage (UFS) drive, a secure digital (SD) card, and a hard disk drive (HDD). Examples of memory modules include a dual in-line memory module (DIMM), a small outline DIMM (SO-DIMM), and various types of non-volatile dual in-line memory module (NVDIMM).

The computing system can be a computing device such as a desktop computer, a laptop computer, a network server, a mobile device, a vehicle (e.g., airplane, drone, train, automobile, or other conveyance), an internet of things (IoT) enabled device, an embedded computer (e.g., one included in a vehicle, industrial equipment, or a networked commercial device), or such a computing device that includes memory and a processing device.

The computing system can include a host system 310 that is coupled to one or more memory sub-systems 301. **FIG. 10** illustrates one example of a host system 310 coupled to one memory sub-system 301. As used herein, "coupled to" or "coupled with" generally refers to a connection between components, which can be an indirect communicative connection or direct communicative connection (e.g., without intervening components), whether wired or wireless, including connections such as electrical, optical, magnetic, etc.

The host system 310 can include a processor chipset (e.g., processing device 311) and a software stack executed by the processor chipset. The processor chipset can include one or more cores, one or more caches, a memory controller (e.g., controller 313) (e.g., NVDIMM controller), and a storage protocol controller (e.g., PCIe controller, SATA controller). The host system 310 uses the memory sub-system 301, for example, to write data to the memory sub-system 301 and read data from the memory sub-system 301.

The host system 310 can be coupled to the memory sub-system 301 via a physical host interface 309. Examples of a physical host interface 309 include, but are not limited to, a serial advanced technology attachment (SATA) interface, a peripheral component interconnect express (PCle) interface, a universal serial bus (USB) interface, a fibre channel, a serial attached SCSI (SAS) interface, a double data rate (DDR) memory bus interface, a small computer system interface (SCSI), a dual in-line memory module (DIMM) interface (e.g., DIMM socket interface that supports double data rate (DDR)), an open NAND flash interface (ONFI), a double data rate (DDR) interface, a low power double data rate (LPDDR) interface, or any other interface. The physical host interface 309 can be used to transmit data between the host system 310 and the memory sub-system 301. The host system 310 can further utilize an NVM express (NVMe) interface to access components (e.g., memory devices 323) when the memory sub-system 301 is coupled with the host system 310 by the PCIe interface. The physical host interface 309 can provide an interface for passing control, address, data, and other signals between the memory sub-system 301 and the host system 310. **FIG. 10** illustrates a memory sub-system 301 as an example. In general, the host system 310 can access multiple memory sub-systems via a same communication connection, multiple separate communication connections, and/or a combination of communication connections.

The processing device 311 of the host system 310 can be, for example, a microprocessor, a central processing unit (CPU), a processing core of a processor, an execution unit, etc. In some instances, the controller 313 can be referred to as a memory controller, a memory management unit, and/or an initiator. In one example, the controller 313 controls the communications over a bus coupled between the host system 310 and the memory sub-system 301. In general, the controller 313 can send commands or requests to the memory sub-system 301 for desired access to memory devices 323, 321. The controller 313 can further include interface circuitry to communicate with the memory sub-system 301. The interface circuitry can convert responses received from the memory sub-system 301 into information for the host system 310.

The controller 313 of the host system 310 can communicate with the controller 303 of the memory sub-system 301 to perform operations such as reading data, writing data, or erasing data at the memory devices 323, 321 and other such operations. In some instances, the controller 313 is integrated within the same package of the processing device 311. In other instances, the controller 313 is separate from the package of the processing device 311. The controller 313 and/or the processing device 311 can include hardware such as one or more integrated circuits (ICs) and/or discrete components, a buffer memory, a cache memory, or a combination thereof. The controller 313 and/or the processing device 311 can be a microcontroller, special purpose logic circuitry (e.g., a field programmable gate array (FPGA), an application specific integrated circuit (ASIC), etc.), or another suitable processor.

The memory devices 323, 321 can include any combination of the different types of non-volatile memory components and/or volatile memory components. The volatile memory devices (e.g., memory device 321) can be, but are not limited to, random access memory (RAM), such as dynamic random access memory (DRAM) and synchronous dynamic random access memory (SDRAM).

Some examples of non-volatile memory components include a negative-and (or, NOT AND) (NAND) type flash memory and write-in-place memory, such as three-dimensional cross-point ("3D cross-point") memory. A cross-point array of non-volatile memory can perform bit storage based on a change of bulk resistance, in conjunction with a stackable cross-gridded data access array. Additionally, in contrast to many flash-based memories, cross-point non-volatile memory can perform a write in-place operation, where a non-volatile memory cell can be programmed without the non-volatile memory cell being previously erased. NAND type flash memory includes, for example, two-dimensional NAND (2D NAND) and three-dimensional NAND (3D NAND).

Each of the memory devices 323 can include one or more arrays of memory cells. One type of memory cell, for example, single level cells (SLC) can store one bit per cell. Other types of memory cells, such as multi-level cells (MLCs), triple level cells (TLCs), quad-level cells (QLCs), and penta-level cells (PLCs) can store multiple bits per cell. In some embodiments, each of the memory devices 323 can include one or more arrays of memory cells such as SLCs, MLCs, TLCs, QLCs, PLCs, or any combination of such. In some embodiments, a particular memory device can include an SLC portion, an MLC portion, a TLC portion, a QLC portion, and/or a PLC portion of memory cells. The memory cells of the memory devices 323 can be grouped as pages that can refer to a logical unit of the memory device used to store data. With some types of memory (e.g., NAND), pages can be grouped to form blocks.

Although non-volatile memory devices such as 3D cross-point type and NAND type memory (e.g., 2D NAND, 3D NAND) are described, the memory device 323 can be based on any other type of non-volatile memory, such as read-only memory (ROM), phase-change memory (PCM), self-selecting memory, other chalcogenide based memories, ferroelectric transistor random-access memory (FeTRAM), ferroelectric random access memory (FeRAM), magneto random access memory (MRAM), spin transfer torque (STT)-MRAM, conductive bridging RAM (CBRAM), resistive random access memory (RRAM), oxide based RRAM (OxRAM), negative-or (NOR) flash memory, and electrically erasable programmable read-only memory (EEPROM).

A memory sub-system controller 303 (or controller 303 for simplicity) can communicate with the memory devices 323 to perform operations such as reading data, writing data, or erasing data at the memory devices 323 and other such operations (e.g., in response to commands scheduled on a command bus by controller 313). The controller 303 can include hardware such as one or more integrated circuits (ICs) and/or discrete components, a buffer memory, or a combination thereof. The hardware can include digital circuitry with dedicated (i.e., hard-coded) logic to perform the operations described herein. The controller 303 can be a microcontroller, special purpose logic circuitry (e.g., a field programmable gate array (FPGA), an application specific integrated circuit (ASIC), etc.), or another suitable processor.

The controller 303 can include a processing device 307 (processor) configured to execute instructions stored in a local memory 305. In the illustrated example, the local memory 305 of the controller 303 includes an embedded memory configured to store instructions for performing various processes, operations, logic flows, and routines that control operation of the memory sub-system 301, including handling communications between the memory sub-system 301 and the host system 310.

In some embodiments, the local memory 305 can include memory registers storing memory pointers, fetched data, etc. The local memory 305 can also include read-only memory (ROM) for storing micro-code. While the example memory sub-system 301 in **FIG. 10** has been illustrated as including the controller 303, in another embodiment of the present disclosure, a memory sub-system 301 does not include a controller 303, and can instead rely upon external control (e.g., provided by an external host, or by a processor or controller separate from the memory sub-system).

In general, the controller 303 can receive commands or operations from the host system 310 and can convert the commands or operations into instructions or appropriate commands to achieve the desired access to the memory devices 323. The controller 303 can be responsible for other operations such as wear leveling operations, garbage collection operations, error detection and error-correcting code (ECC) operations, encryption operations, caching operations, and address translations between a logical address (e.g., logical block address (LBA), namespace) and a physical address (e.g., physical block address) that are associated with the memory devices 323. The controller 303 can further include host interface circuitry to communicate with the host system 310 via the physical host interface. The host interface circuitry can convert the commands received from the host system into command instructions to access the memory devices 323 as well as convert responses associated with the memory devices 323 into information for the host system 310.

The memory sub-system 301 can also include additional circuitry or components that are not illustrated. In some embodiments, the memory sub-system 301 can include a cache or buffer (e.g., DRAM) and address circuitry (e.g., a row decoder and a column decoder) that can receive an address from the controller 303 and decode the address to access the memory devices 323.

In some embodiments, the memory devices 323 include local media controllers 325 that operate in conjunction with the memory sub-system controller 303 to execute operations on one or more memory cells of the memory devices 323. An external controller (e.g., memory sub-system controller 303) can externally manage the memory device 323 (e.g., perform media management operations on the memory device 323). In some embodiments, a memory device 323 is a managed memory device, which is a raw memory device combined with a local controller (e.g., local media controller 325) for media management within the same memory device package. An example of a managed memory device is a managed NAND (MNAND) device.

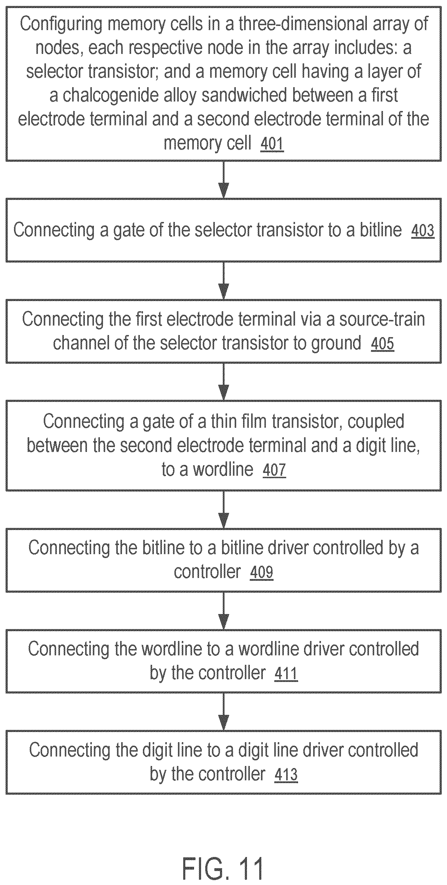

**FIG. 11** shows a method to access memory cells in a three dimensional array according to one embodiment, such as an array discussed above in connection with **FIG. 1** to **FIG. 10**.

At block 401, the method of **FIG. 11** includes configuring memory cells in a three-dimensional array of nodes (e.g., 101, 103; 102, 104) of a memory device 230. Each respective node (e.g., 101 or 102) in the array includes: a selector transistor (e.g., 131 or 132); and a memory cell (e.g., 141 or 142) having a layer of a chalcogenide alloy (e.g., 153) sandwiched between a first electrode terminal (e.g., 155) and a second electrode terminal (e.g., 151) of the memory cell (e.g., 141).

For example, the node can have the structure such that when the chalcogenide alloy 153 is replaced with an isolation material, the respective node becomes a dynamic random access memory cell. For example, the node can have the structure such that when the chalcogenide alloy 153 is replaced with a ferroelectric material the respective node becomes a ferroelectric random access memory (FeRAM) cell. Thus, a manufacturing facility can be advantageously configured to easily change between producing a memory chip having non-volatile memory cells programmable to have polarity induced threshold windows, producing a memory chip having volatile dynamic random access memory cells, and/or producing a memory chip having ferroelectric random access memory cells.

For example, the method can include depositing, the chalcogenide alloy 153 including a ternary Indium-Arsenic-Selenium material 157 or a ternary Indium-Arsenic-Tellurium material 159, using a technique of atomic layer deposition. In some implementations, the chalcogenide alloy 153 can be replaced with a doped ternary compound (e.g., silicon (Si) doped primarily three items from selenium (Se), tellurium (Te), arsenic (As), antimony (Sb), carbon (C), germanium (Ge), and indium (In)).

At block 403, the method includes connecting a gate of the selector transistor (e.g., 131) to a bitline (e.g., via a horizontal plate 111 configured above the node 101).

At block 405, the method includes connecting the first electrode terminal (e.g., 155) via a source-drain channel of the selector transistor (e.g., 131) to ground (e.g., via a vertical pillar 121 next to the node 101).

At block 407, the method includes connecting a gate of a thin film transistor (e.g., 151) to a wordline (e.g., 127), where the thin film transistor (e.g., 151) is electrically coupled between the second electrode terminal (e.g., 151) and a digit line (e.g., 129) (e.g., via a vertical pillar 123).

At block 409, the method includes connecting the bitline to a bitline driver 247 controlled by a controller 231 of the memory device 230.

At block 411, the method includes connecting the wordline to a wordline driver 245 controlled by the controller 231.

At block 413, the method includes connecting the digit line 129 to a digit line driver 249 controlled by the controller 231.

For example, the method can further include: selecting the memory cell (e.g., 141 or 201) by the controller 231 controlling the bitline driver 247 to drive a voltage to turn on the selector transistor (e.g., 131), and controlling the wordline driver 245 to drive a voltage to turn on the thin film transistor (e.g., 253 or 151).

Once the memory cell (e.g., 141 or 201) is selected/addressed using the bitline driver 247 and the wordline driver 245, the method can further include: programming the memory cell (e.g., 141 or 201) to have a polarity induced threshold window by controlling the digit line driver 249 to cause a current lower than 50 µA, to flow through the memory cell (e.g., 141 or 201).

In one embodiment, an example machine of a computer system within which a set of instructions, for causing the machine to perform any one or more of the methods discussed herein, can be executed. In some embodiments, the computer system can correspond to a host system that includes, is coupled to, or utilizes a memory sub-system or can be used to perform the operations described above. In alternative embodiments, the machine can be connected (e.g., networked) to other machines in a LAN, an intranet, an extranet, or the internet, or any combination thereof. The machine can operate in the capacity of a server or a client machine in client-server network environment, as a peer machine in a peer-to-peer (or distributed) network environment, or as a server or a client machine in a cloud computing infrastructure or environment.

The machine can be a personal computer (PC), a tablet PC, a set-top box (STB), a personal digital assistant (PDA), a cellular telephone, a web appliance, a server, a network router, a switch or bridge, a network-attached storage facility, or any machine capable of executing a set of instructions (sequential or otherwise) that specify actions to be taken by that machine. Further, while a single machine is illustrated, the term "machine" shall also be taken to include any collection of machines that individually or jointly execute a set (or multiple sets) of instructions to perform any one or more of the methodologies discussed herein.

The example computer system includes a processing device, a main memory (e.g., read-only memory (ROM), flash memory, dynamic random access memory (DRAM) such as synchronous DRAM (SDRAM) or Rambus DRAM (RDRAM), static random access memory (SRAM), etc.), and a data storage system, which communicate with each other via a bus (which can include multiple buses).

Processing device represents one or more general-purpose processing devices such as a microprocessor, a central processing unit, or the like. More particularly, the processing device can be a complex instruction set computing (CISC) microprocessor, reduced instruction set computing (RISC) microprocessor, very long instruction word (VLIW) microprocessor, or a processor implementing other instruction sets, or processors implementing a combination of instruction sets. Processing device can also be one or more special-purpose processing devices such as an application specific integrated circuit (ASIC), a field programmable gate array (FPGA), a digital signal processor (DSP), network processor, or the like. The processing device is configured to execute instructions for performing the operations and steps discussed herein. The computer system can further include a network interface device to communicate over the network.

The data storage system can include a machine-readable medium (also known as a computer-readable medium) on which is stored one or more sets of instructions or software embodying any one or more of the methodologies or functions described herein. The instructions can also reside, completely or at least partially, within the main memory and within the processing device during execution thereof by the computer system, the main memory and the processing device also constituting machine-readable storage media. The machine-readable medium, data storage system, or main memory can correspond to the memory sub-system.

In one embodiment, the instructions include instructions to implement functionality corresponding to the operations described above. While the machine-readable medium is shown in an example embodiment to be a single medium, the term "machine-readable storage medium" should be taken to include a single medium or multiple media that store the one or more sets of instructions. The term "machine-readable storage medium" shall also be taken to include any medium that is capable of storing or encoding a set of instructions for execution by the machine and that cause the machine to perform any one or more of the methodologies of the present disclosure. The term "machine-readable storage medium" shall accordingly be taken to include, but not be limited to, solid-state memories, optical media, and magnetic media.

Some portions of the preceding detailed descriptions have been presented in terms of algorithms and symbolic representations of operations on data bits within a computer memory. These algorithmic descriptions and representations are the ways used by those skilled in the data processing arts to convey the substance of their work most effectively to others skilled in the art. An algorithm is here, and generally, conceived to be a self-consistent sequence of operations leading to a desired result. The operations are those requiring physical manipulations of physical quantities. Usually, though not necessarily, these quantities take the form of electrical or magnetic signals capable of being stored, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. The present disclosure can refer to the action and processes of a computer system, or similar electronic computing device, that manipulates and transforms data represented as physical (electronic) quantities within the computer system's registers and memories into other data similarly represented as physical quantities within the computer system memories or registers or other such information storage systems.

The present disclosure also relates to an apparatus for performing the operations herein. This apparatus can be specially constructed for the intended purposes, or it can include a general-purpose computer selectively activated or reconfigured by a computer program stored in the computer. Such a computer program can be stored in a computer readable storage medium, such as, but not limited to, any type of disk including floppy disks, optical disks, CD-ROMs, and magnetic-optical disks, read-only memories (ROMs), random access memories (RAMs), EPROMs, EEPROMs, magnetic or optical cards, or any type of media suitable for storing electronic instructions, each coupled to a computer system bus.

The algorithms and displays presented herein are not inherently related to any particular computer or other apparatus. Various general-purpose systems can be used with programs in accordance with the teachings herein, or it can prove convenient to construct a more specialized apparatus to perform the method. The structure for a variety of these systems will appear as set forth in the description below. In addition, the present disclosure is not described with reference to any particular programming language. It will be appreciated that a variety of programming languages can be used to implement the teachings of the disclosure as described herein.

The present disclosure can be provided as a computer program product, or software, that can include a machine-readable medium having stored thereon instructions, which can be used to program a computer system (or other electronic devices) to perform a process according to the present disclosure. A machine-readable medium includes any mechanism for storing information in a form readable by a machine (e.g., a computer). In some embodiments, a machine-readable (e.g., computer-readable) medium includes a machine (e.g., a computer) readable storage medium such as a read only memory ("ROM"), random access memory ("RAM"), magnetic disk storage media, optical storage media, flash memory components, etc.

In this description, various functions and operations are described as being performed by or caused by computer instructions to simplify description. However, those skilled in the art will recognize what is meant by such expressions is that the functions result from execution of the computer instructions by one or more controllers or processors, such as a microprocessor. Alternatively, or in combination, the functions and operations can be implemented using special-purpose circuitry, with or without software instructions, such as using application-specific integrated circuit (ASIC) or field-programmable gate array (FPGA). Embodiments can be implemented using hardwired circuitry without software instructions, or in combination with software instructions. Thus, the techniques are limited neither to any specific combination of hardware circuitry and software, nor to any particular source for the instructions executed by the data processing system.

In the foregoing specification, embodiments of the disclosure have been described with reference to specific example embodiments thereof. It will be evident that various modifications can be made thereto without departing from the broader spirit and scope of embodiments of the disclosure as set forth in the following claims. The specification and drawings are, accordingly, to be regarded in an illustrative sense rather than a restrictive sense.

## Claims

1. A memory device (230, 321, 323), comprising:
a three-dimensional array of nodes (101, 102, 103, 104) configured on a semiconductive substrate, each respective node (101, 102, 103, 104) in the array having:
a selector transistor (131, 132); and
a memory cell (141, 142, 201, 202) having:
a first layer of conductive material configured as a first electrode terminal (155) of the memory cell (141, 142, 201, 202), the first electrode terminal (155) connected to the selector transistor (131, 132);
a second layer of conductive material configured as a second electrode terminal (151) of the memory cell (141, 142, 201, 202); and
a layer of a chalcogenide alloy (153) sandwiched between the first electrode terminal (155) and the second electrode terminal (151).

2. The memory device (230, 321, 323) of claim 1, wherein the chalcogenide alloy (153) includes a ternary Indium-Arsenic-Selenium material, or a ternary Indium-Arsenic-Tellurium material.

3. The memory device (230, 321, 323) of claim 1, wherein the memory cell (141, 142, 201, 202) is programmable to have a polarity induced threshold window.

4. The memory device (230, 321, 323) of claim 3, wherein the memory cell (141, 142, 201, 202) is programmable, via a current lower than 50 µA, to have the polarity induced threshold window.

5. The memory device (230, 321, 323) of claim 3, wherein the chalcogenide alloy (153) is deposited via a technique of atomic layer deposition, or a technique of physical vapor deposition.

6. The memory device (230, 321, 323) of claim 3, wherein the three-dimensional array of nodes (101, 102, 103, 104) include:
first nodes (101, 103) stacked in a first direction; and
second nodes (102, 104) stacked in the first direction and configured next to the first nodes (101, 103) in a slice of nodes extending in the first direction and a second direction;
wherein the memory device (230, 321, 323) includes a conductive pillar (123) extending in the first direction and configured between the first nodes (101, 103) and the second nodes (102, 104); and
wherein each of the first nodes (101, 103) and the second nodes (102, 104) has an electrode terminal connected to the conductive pillar (123).

7. The memory device (230, 321, 323) of claim 6, wherein the conductive pillar (123) is a first conductive pillar (123); and the memory device (230, 321, 323) further comprises:
a second conductive pillar (121) running in parallel with the first conductive pillar (123), wherein each of the first nodes (101, 103) has a source-drain channel connecting a memory cell (141, 142, 201, 202) between the first conductive (123) pillar and the second conductive pillar (121); and
a plurality of horizontal plates (111, 112, 113, 114) running in a third direction, wherein each of the horizontal plates (111, 112, 113, 114) is connected to a gate of a selector transistor (131, 132) in one of the first nodes (101, 103).

8. The memory device (230, 321, 323) of claim 7, further comprising:
a wordline (127) running in parallel with the slice and in the second direction;
a digit line (129) running in the third direction that is perpendicular to the slice; and
a thin film transistor (151) formed through the wordline (127), the thin film transistor (151) having:
a gate in connection with the wordline (127); and
a source-drain channel configured to connect the first conductive pillar (123) to the digit line (129).

9. The memory device (230, 321, 323) of claim 8, further comprising:
a plurality of bitline driver (237, 247) connected to the plurality of horizontal plates (111, 112, 113, 114) respectively;
a wordline driver (235, 245) connected to the wordline (127); and
a digit line driver (239, 249) connected to the digit line (129).

10. An apparatus containing the three-dimensional array of nodes (101, 102, 103, 104) of claim 1, further comprising:
a controller (231);
bitline drivers (237, 247) controlled by the controller (231);
wordline drivers (235, 245) controlled by the controller (231);
digit line drivers (239, 249) controlled by the controller (231); and
a digit line (129) connected to one of the digit line drivers (239, 249);
a thin film transistor (151) having a source-drain channel and a gate;
wherein a gate of the selector transistor (131, 132) is connected to one of the bitline drivers (237, 247);
wherein the second electrode terminal (151) of the memory cell (141, 142, 201, 202) is connected via the source-drain channel of the thin film transistor (151) to the digit line (129); and
wherein the gate of the thin film transistor (151) is connected to one of the wordline drivers (235, 245).

11. The apparatus of claim 10, wherein the chalcogenide alloy (153) includes a ternary Indium-Arsenic-Selenium material or a ternary Indium-Arsenic-Tellurium material, deposited via a technique of atomic layer deposition; and
wherein the memory cell (141, 142, 201, 202) is programmable, via a current lower than 50 µA, to have a polarity induced threshold window.

12. A method, comprising:
configuring memory cells (141, 142, 201, 202) in a three-dimensional array of nodes (101, 102, 103, 104), each respective node (101, 102, 103, 104) in the array includes: a selector transistor (131, 132); and a memory cell (141, 142, 201, 202) having a layer of a chalcogenide alloy (153) sandwiched between a first electrode terminal (155) and a second electrode terminal (151) of the memory cell (141, 142, 201, 202);
connecting a gate of the selector transistor (131, 132) to a bitline;
connecting the first electrode terminal (155) via a source-drain channel of the selector transistor (131, 132) to ground;
connecting a gate of a thin film transistor (151), coupled between the second electrode terminal (151) and a digit line (129), to a wordline (127);
connecting the bitline to a bitline driver (237, 247) controlled by a controller (231);
connecting the wordline (127) to a wordline driver (235, 245) controlled by the controller (231);
connecting the digit line (129) to a digit line driver (239, 249) controlled by the controller (231).

13. The method of claim 12, further comprising:
depositing, the chalcogenide alloy (153) including a ternary Indium-Arsenic-Selenium material or a ternary Indium-Arsenic-Tellurium material, using a technique of atomic layer deposition.

14. The method of claim 13, further comprising:
selecting the memory cell (141, 142, 201, 202) by controlling the bitline driver (237, 247) to drive a voltage to turn on the selector transistor (131, 132), and controlling the wordline driver (235, 245) to drive a voltage to turn on the thin film transistor (151).

15. The method of claim 14, further comprising:
programming the memory cell (141, 142, 201, 202) to have a polarity induced threshold window by controlling the digit line driver (239, 249) to cause a current lower than 50 µA, to flow through the memory cell (141, 142, 201, 202).
